Europäisches Patentamt

European Patent Office

Office européen des brevets

(11) Veröffentlichungsnummer: **0 386 822**
**A2**

(12) **EUROPÄISCHE PATENTANMELDUNG**

(21) Anmeldenummer: 90200448.0

(22) Anmeldetag: 26.02.90

(51) Int. Cl.⁵: **G01R 33/48**

(30) Priorität: 04.03.89 DE 3906979

(43) Veröffentlichungstag der Anmeldung:
**12.09.90 Patentblatt 90/37**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**

**Groenewoudseweg 1**
**NL-5621 BA Eindhoven(NL)**
(84) **FR GB IT**

(72) Erfinder: **Holz, Dietrich Joachim Karl, Dr.**
**Nordalbinger Weg 15**
**D-2000 Hamburg 61(DE)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Kernspinuntersuchungsverfahren und Anordnung zur Durchführung des Verfahrens.**

(57) Die Erfindung beschreibt ein Verfahren zur Bestimmung der spektralen oder räumlichen Verteilung der Kernmagnetisierung in einem begrenzten Volumenbereich. Dabei wirken in Anwesenheit eines homogenen stationären Magnetfeldes vier Hochfrequenzimpulse auf den Untersuchungsbereich ein, von denen die letzten beiden und einer der beiden ersten schichtselektiv sind und der zweite Hochfrequenzimpuls ein 180°-Impuls ist. Damit ist es möglich, die Kernmagnetisierung im Schnittbereich der durch die drei Hochfrequenzimpulse angeregten Schichten zur Erzeugung eines FID-Signals oder eines Spin-Echo-Signals zu verwenden.

EP 0 386 822 A2

Fig. 3

# Kernspinuntersuchungsverfahren und Anordnung zur Durchführung des Verfahrens

Die Erfindung betrifft ein Verfahren zur Bestimmung der spektralen oder der räumlichen Verteilung der Kernmagnetisierung in einem Volumenbereich mit Hilfe einer Sequenz, die wenigstens drei schichtselektive Hochfrequenzimpulse umfaßt, wodurch drei zueinander senkrechte Schichten angeregt werden und das im Schnittbereich dieser Schichten erzeugte Kernresonanzsignal ausgenutzt wird sowie eine Anordnung zur Durchführung dieses Verfahrens.

Ein Verfahren der eingangs genannten Art dient der Volumenselektion, d.h. es sollen nur Kernresonanzsignale aus einem Volumenbereich verarbeitet werden, der von einem größeren Volumen umschlossen wird und in der Regel im Inneren eines Patienten liegt. Die Signale aus dem selektierten Volumenbereich können sowohl zur Spektroskopie als auch zur Bildgebung verwendet werden.

Bei einem aus der EP-OS 2 33 675 bekannten Verfahren der eingangs genannten Art wird ein Volumenbereich durch drei Hochfrequenzimpulse angeregt, die von magnetischen Gradientenfeldern mit in drei zueinander senkrechten Richtungen verlaufenden Gradienten begleitet sind. Die dabei in den drei angeregten Schichten auftretenden FID-Signale sowie die Spin-Echo-Signale aus · den Schnittbereichen jeweils zweier Schichten werden durch magnetische Gradientenfelder dephasiert, die zwischen bzw. nach den drei Hochfrequenzimpulsen wirksam sind. Es verbleibt somit nur ein stimuliertes Echosignal, das aus einem Volumenbereich stammt, der dem Schnittbereich der drei Schichten entspricht. Bei Verfahren, die mit stimulierten Echosignalen arbeiten, wird aber bekanntlich nur die Hälfte der durch die Hochfrequenzimpulse angeregten Kernmagnetisierung ausgenutzt.

Aufgabe der vorliegenden Erfindung ist es, ein anderes Verfahren zur Volumenselektion anzugeben.

Eine erste Lösung dieser Aufgabe sieht vor, daß die Sequenz mindestens vier Hochfrequenzimpulse umfaßt, von denen der erste, der dritte und der vierte schichtselektiv sind und je drei Schichten anregen, daß zwischen dem ersten und dem dritten Hochfrequenzimpuls - vorzugsweise in der Mitte - ein 180°-Hochfrequenzimpuls vorgesehen ist, daß ein Phasencycling mit je zwei Sequenzen durchgeführt wird, und daß sich in diesen beiden Sequenzen die Phasenlage des ersten oder des dritten der vier Hochfrequenzimpulse um 180° oder die Phasenlage des zweiten um 90° unterscheidet.

Eine zweite Lösung dieser Aufgabe sieht vor, daß die Sequenz wenigstens vier Hochfrequenzimpulse umfaßt, von denen der zweite, der dritte und der vierte schichtselektiv sind und je drei Schichten anregen und daß der zweite zwischen dem ersten und dem dritten Hochfrequenzimpuls - vorzugsweise in der Mitte - liegende Hochfrequenzimpuls ein 180°-Impuls ist.

Die beiden Lösungen haben gemeinsam, daß jede Sequenz (wenigstens) vier Hochfrequenzimpulse umfaßt, von denen der zweite ein 180°-Impuls ist, während die drei anderen Hochfrequenzimpulse die Kernmagnetisierung um 90° kippen. Die beiden letzten Hochfrequenzimpulse sind schichtselektive Impulse, durch die zwei zueinander senkrechte Schichten angeregt werden.

Bei der ersten Lösung ist auch der erste Hochfrequenzimpuls schichtselektiv, d.h. er wird von einem magnetischen Gradientenfeld begleitet, dessen Gradient senkrecht zu den Gradienten der die beiden letzten Hochfrequenzimpulse begleitenden Gradientenfelder verläuft. Man erhält somit von der Kernmagnetisierung aus dem Schnittbereich der drei Schichten, jedoch auch aus Teilen der zuletzt angeregten Schicht, die durch den ersten und dritten Hochfrequenzimpuls nicht angeregt wurden, ein FID-Signal bzw. - falls noch ein 180°-Impuls folgt - ein Spin-Echo-Signal. Die Signalkomponenten aus den außerhalb des Schnittbereichs liegenden Bereichen lassen sich durch Phasencycling unterdrücken, indem die Sequenz ein zweites Mal wiederholt wird, wobei die Phasenlage des ersten oder dritten Hochfrequenzimpulses um 180° oder die des zweiten um 90° geändert wird. Dadurch wird erreicht, daß die Kernmagnetisierung in dem Schnittbereich eine um 180° versetzte Phasenlage hat, während sie in den erwähnten Bereichen außerhalb des Schnittbereichs ihre Phasenlage nicht ändert. Durch Substraktion der bei den beiden Sequenzen erhaltenen Signale ergibt sich somit ein Kernresonanzsignal, das ausschließlich dem Schnittbereich der drei Schichten zugeordnet ist.

Bei der zweiten Lösung wird die dritte Schicht selektiv durch den zweiten Hochfrequenzimpuls, den 180°-Hochfrequenzimpuls, angeregt. Dies führt dazu, daß nach dem vierten Hochfrequenzimpuls nur in dem erwähnten Schnittbereich die Richtung der Kernmagnetisierung nicht mit der Richtung des stationären homogenen Magnetfeldes (oder der Gegenrichtung) zusammenfällt, in dessen Anwesenheit die Sequenzen durchgeführt werden. Der Vorteil gegenüber der ersten Lösung besteht darin, daß der Volumenbereich bereits mit einer Sequenz selektiert wird, so daß ein Phasencycling zur Volumenselektion nicht notwendig ist. Damit entfallen auch die Probleme, die durch ein nicht ideales Anregungsprofil innerhalb der selektierten Schicht entstehen. Dem steht der Nachteil gegenüber, daß ein schichtselektiver 180°-Hochfrequenzimpuls erforderlich ist.

Beide Lösungen haben gegenüber dem eingangs erwähnten bekannten Verfahren den Vorteil, daß die volle Kernmagnetisierung in dem selektierten Volumenbereich für die Kernresonanzsignale genutzt werden kann und nicht nur die Hälfte, wie bei einem stimulierten Echosignal. Eine Ausführungsform der Erfindung gemäß der ersten bzw. der zweiten Lösung ist dadurch gekennzeichnet, daß die nicht schichtselektiven Hochfrequenzimpulse frequenzselektiv sind. Damit wirkt der Sequenz nur auf Protonen einer chemischen Verbindung.

Eine Anordnung zur Durchführung des erfindungsgemäßen Verfahrens ist gekennzeichnet durch einen Magneten zur Erzeugung eines homogenen stationären Magnetfeldes, eine Hochfrequenzspule zur Erzeugung von zur Richtung des stationären Magnetfeldes senkrechten hochfrequenten Magnetfeldern, einem Hochfrequenzgenerator zur Speisung der Hochfrequenzspule mit Signalen, deren Frequenz steuerbar ist, mehreren Gradientenspulen zur Erzeugung von Magnetfeldern, die in der gleichen Richtung verlaufen wie das stationäre Magnetfeld und deren Gradienten in unterschiedlichen Richtungen verlaufen, Generatoren, die den Gradientenspulen je einen Strom mit vorgegebener Amplitude zuführen und eine Steuereinheit, die den Hochfrequenzgenerator und die Generatoren für die Gradientenspulen so steuert, daß vier Hochfrequenzimpulse erzeugt werden, von denen die beiden letzten sowie einer der beiden ersten schichtselektiv sind, wobei der zweite Hochfrequenzimpuls ein 180°-Impuls ist.

Die Erfindung wird nachstehend anhand der Zeichnung näher erläutert. Es zeigen

Fig. 1 ein Kernspinuntersuchungsgerät zur Durchführung des erfindungsgemäßen Verfahrens,

Fig. 2 ein Blockschaltbild eines solchen Gerätes,

Fig. 3 den zeitlichen Verlauf verschiedener Signale bei einem ersten Verfahren,

Fig. 4 die zeitlichen Veränderungen der Kernmagnetisierung in den verschiedenen Bereichen des Untersuchungsobjektes bei diesem Verfahren,

Fig. 5 den zeitlichen Verlauf verschiedener Signale bei einem zweiten Verfahren,

und Fig. 6 die dabei sich ergebenden zeitlichen Veränderungen der Kernmagnetisierung in verschiedenen Bereichen des Untersuchungsobjektes.

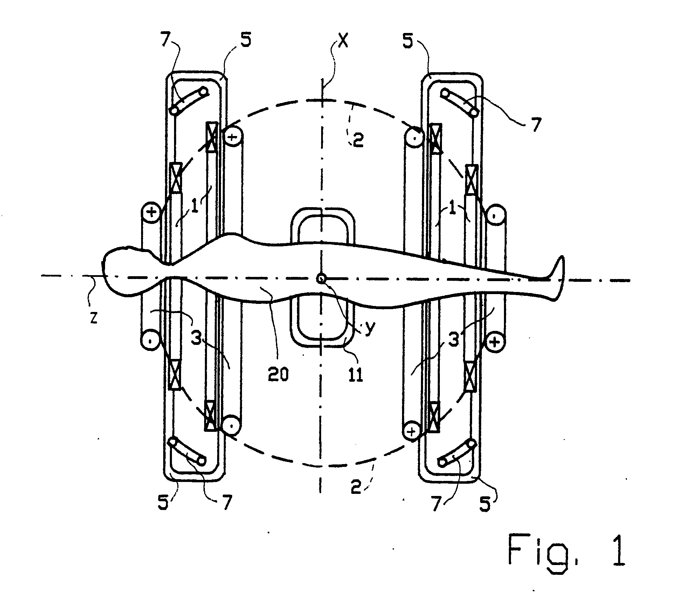

Das in Fig. 1 schematisch dargestellte Kernspinuntersuchungsgerät enthält eine aus vier Spulen 1 bestehende Anordnung zur Erzeugung eines homogenen stationären Magnetfeldes, das in der Größenordnung von einigen zehntel Tesla bis einigen Tesla liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die mit den Spulen 7 identisch sein können, die jedoch diesen gegenüber um 90° räumlich versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy, Gx symmetrisch zur Kugeloberfläche 2 angeordnet ist, ist die Feldstärke im Kugelzentrum, das gleichzeitig den Koordinatenursprung des erwähnten kartesischen x-y-z-Koordinatensystems bildet, nur durch das stationäre homogene Magnetfeld der Spulenanordnung 1 bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes hochfrequentes Magnetfeld erzeugt wird, dessen Feldvektor in der x-y-Ebene liegt, d.h. senkrecht auf Richtung des stationären homogenen Magnetfeldes steht. Der Hochfrequenzspule wird während jeden Hochfrequenzimpulses ein hochfrequenter, im allgemeinen frequenz- und/oder amplitudenmodulierter, Strom von einem Hochfrequenzgenerator zugeführt. Im Anschluß an die vier Hochfrequenzimpulse jeder Teilsequenz dient die Hochfrequenzspule 11 zum Empfang des von den Kernen im Untersuchungsbereich emittierten Signals. Stattdessen kann aber auch eine gesonderte Hochfrequenzempfangsspule verwendet werden.

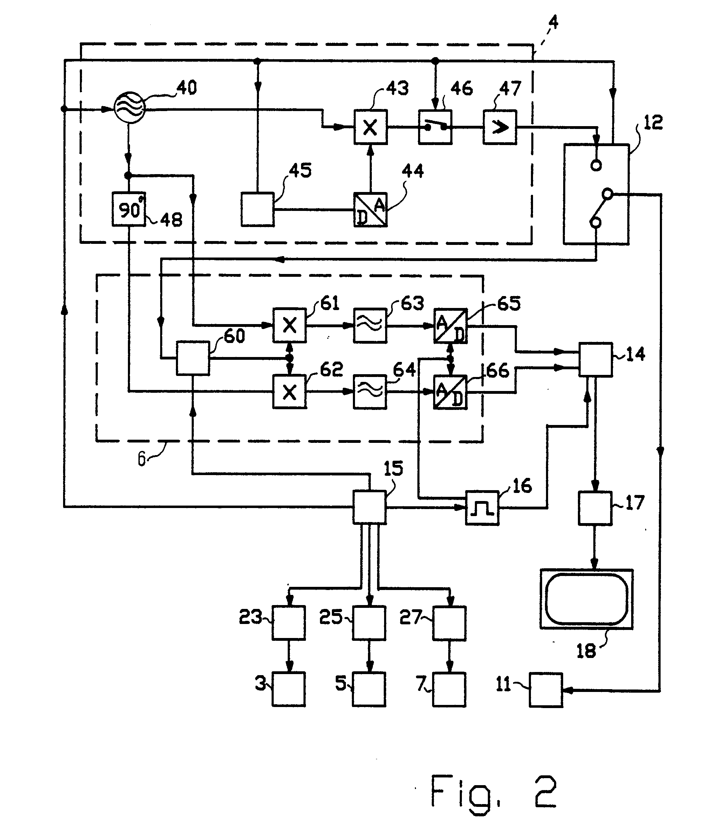

Fig. 2 zeigt ein vereinfachtes Blockschaltbild dieses Kernspinuntersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz von einer Steuereinheit 15 digital steuerbaren Hochfrequenzoszillator 40, der Schwingungen mit einer Frequenz im Bereich der Larmorfrequenz der anzuregende Atomkerne bei der von den Spulen 1 erzeugten Feldstärke aufweist. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Eingang mit einem digitalen Speicher 45 verbunden ist. Aus dem Speicher wird - gesteuert durch die Steuereinrichtung 15 -eine Folge von Hüllkurvensignale darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenzleistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das jeweils in der Hochfrequenzspule 11 induzierte Signal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multipli kativer Mischstufen 61 und 62 verbunden, die jeweils einen dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen diesen Signalen an den Eingängen der Mischstufen eine Phasenverschiebung von 90° besteht. Diese Phasenverschiebung wird mit Hilfe eines 90°-Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadraturdemodulator bildenden Schaltung 61..64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können. Die im Speicher 14 gespeicherten Datenworte bzw. Abtastwerte werden einem Rechner 17 zugeführt, der daraus durch eine diskrete Fouriertransformation die Spektralverteilung der Kernmagnetisierung ermittelt und die ermittelte Verteilung an einer geeigneten Wiedergabeeinheit, z.B. einem Monitor 18, ausgibt.

Die Gradientenspulenanordnungen 3, 5 und 7 werden von Stromgeneratoren 23, 25 und 27 jeweils mit einem Strom versorgt, dessen zeitlicher Verlauf durch die Steuereinheit 15 steuerbar ist.

Die Sequenz beginnt mit einem ersten Hochfrequenzimpuls HFa zur Zeit $t = 0$; während dieses Hochfrequenzimpulses ist also der Hochfrequenzgenerator 4 über die Umschalteinrichtung 12 mit der Hochfrequenzspule verbunden (Fig. 2). Während des Hochfrequenzimpulses HFa ist ein magnetisches Gradientenfeld Gxa mit in x-Richtung verlaufendem Gradienten wirksam, d.h. der Generator 27 liefert der Gradientenspulenanordnung 7 einen Strom mit entsprechendem zeitlichen Verlauf. Es handelt sich somit um einen schichtselektiven Impuls, der die Kernspins in einer zur x-Achse senkrechten Schicht, deren Dicke von der Stärke des Gradienten und der Bandbreite des Hochfrequenzimpulses abhängt, anregt. In dieser Schicht verläuft die Kernmagnetisierung dann also transversal, während sie außerhalb der Schicht in z-Richtung verläuft, d.h. in Richtung des homogenen stationären Magnetfeldes, das von den Spulen 1 erzeugt wird.

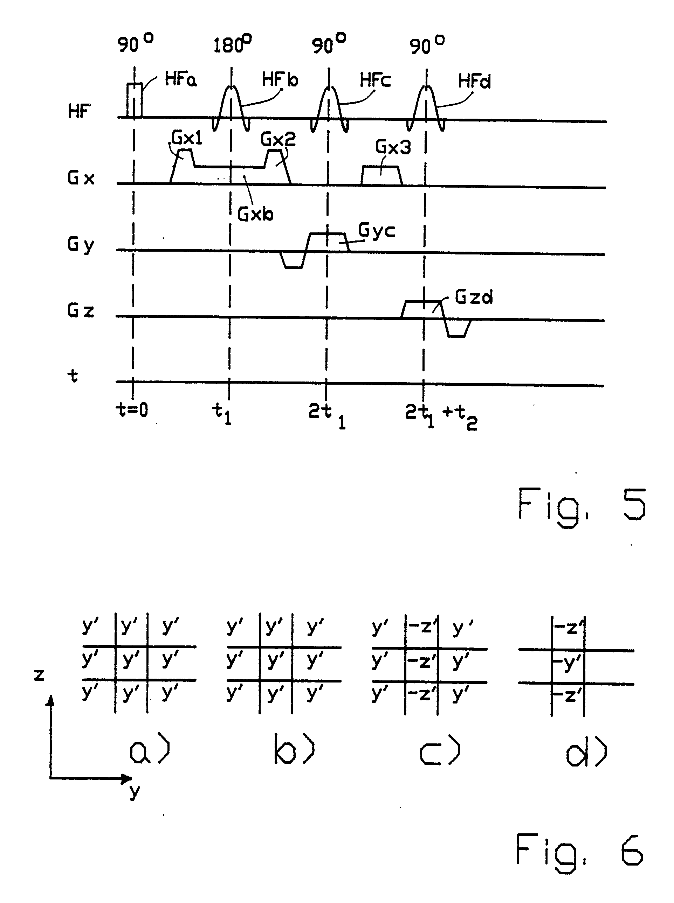

Dies ist in Fig. 4a dargestellt, die für verschiedene Teile des Untersuchungsbereichs die Richtung der Kernmagnetisierung in einem mit der Larmorfrequenz mitrotierenden $x'$-$y'$-$z'$-Koordinatensystem angibt, dessen $z'$-Achse mit der z-Achse des festen x-y-z-Koordinatensystems zusammenfällt. Man erkennt, daß die Kernmagnetisierung in einer vertikalen und zur Zeichenebene senkrechten Schicht in $y'$-Richtung gekippt ist. Beiderseits dieser Schicht wird die Kernmagnetisierung durch den Hochfrequenzimpuls HFa nicht beeinflußt, verbleibt also in $z'$-Richtung.

Nach dem ersten Hochfrequenzimpuls HFa und vor dem zweiten Hochfrequenzimpuls HFb wird ein magnetisches Gradientenfeld $Gx_1$ ein- und ausgeschaltet. Durch dieses Gradientenfeld wird das angeregte FID-Signal dephasiert. Der zweite Hochfrequenzimpuls HFb, der zur Zeit $t = t_1$ eingeschaltet wird, ist nicht schichtselektiv, d.h. während dieses Hochfrequenzimpulses ist kein magnetisches Gradientenfeld wirksam, und er wirkt auf den gesamten Untersuchungsbereich. Wie man anhand von Fig. 4b erkennt, die die Kernmagnetisierung unmittelbar nach diesem Hochfrequenzimpuls zeigt, werden die Kernspins außerhalb der durch den ersten Hochfrequenzimpuls angeregten Schicht in $-z'$-Richtung gekippt, während die Kernmagnetisierung in der zuvor angeregten Schicht innerhalb der $x'$-$y'$-Ebene verbleibt. In welcher Richtung sie dabei verbleibt, hängt von der Phasenlage des zweites Impulses in bezug auf die Phasenlage des ersten Impulses ab. Bei Fig. 4b ist angenommen, daß die Phasenlage so gewählt ist, daß die Kernmagnetisierung weiterhin in $y'$-Richtung weist; jedoch arbeitet die Erfindung auch bei jeder anderen Phasenlage des zweiten Hochfrequenzimpulses.

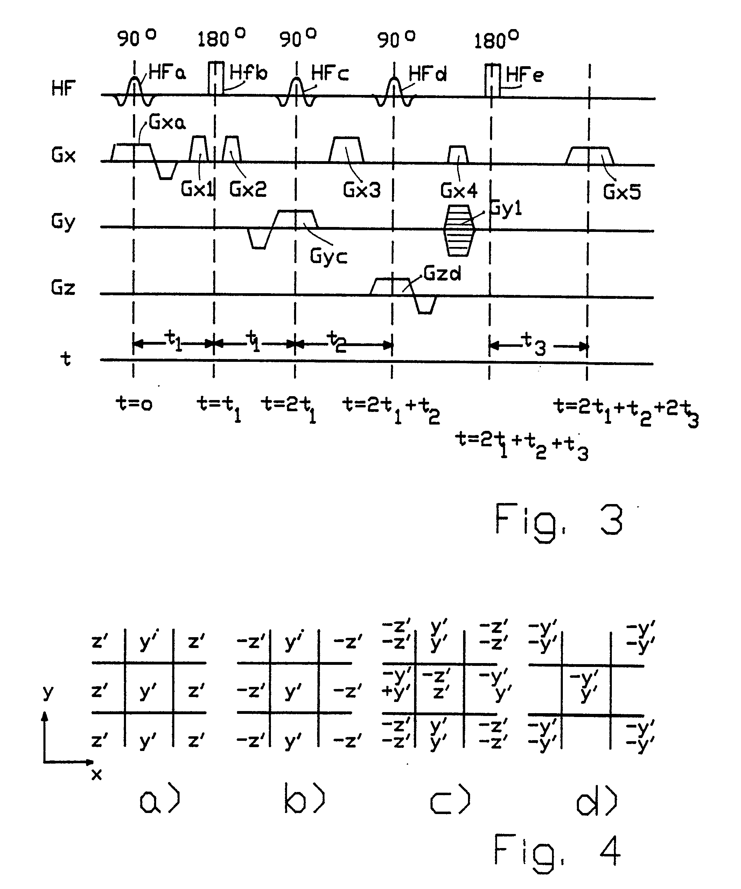

Wie sich aus Fig. 3 weiter ergibt, wird nach dem zweiten Hochfrequenimpuls HFb und vor dem dritten Hochfrequenzimpuls HFC ein magnetisches Gradientenfeld Gx2 ein- und ausgeschaltet, und zwar derart, daß das zeitliche Integral darüber dem zeitlichen Integral über Gx1 entspricht. Infolgedessen kompensiert sich die Wirkung von Gx1 und Gx2 in bezug auf das Spin-Echo, das zur Zeit $t = 2t_1$ als Folge der durch den $180°$-Impuls refokussierten transversalen Magnetisierung sein Maximum hat. Jedoch wird die Kernmagnetisierung, die dadurch entsteht, daß der $180°$-Hochfrequenzimpuls die Kernmagnetisierung nicht überall im Untersuchungsbereich um exakt $180°$ kippt, durch Gx2 dephasiert.

Zur Zeit $t = 2t_1$, also beim Maximum des Spin-Echos, wird der dritte Hochfrequenzimpuls HFc erzeugt, der als $90°$-Hochfrequenzimpuls gestaltet ist. Dieser Impuls wird von einem magnetischen Gradientenfeld Gyc begleitet, so daß dadurch die Kernmagnetisierung in einer zur y-Achse und zur Zeichenebene der Figur 4 senkrechten Schicht beeinflußt wird. Wie sich hierzu aus Fig. 4c ergibt, die die Richtung der Kernmagnetisierung unmittelbar nach dem dritten Hochfrequenzimpuls HFc angibt, beeinflußt der dritte Hochfrequenzimpuls HFc die Kernmagnetisierung in den drei oberen und den drei unteren Bereichen nicht; infolgedessen ist dort die Richtung der Kernmagnetisierung auch unabhängig von der Phasenlage des dritten Hochfrequenzimpulses, d.h. unabhängig davon, in welcher Richtung die Kernmagnetisierung um die $x'$-Achse gedreht wird. Hingegen hängt die Richtung der Kernmagnetisierung in den mittleren drei Feldern, d.h. in der durch den dritten Hochfrequenzimpuls angeregten Schicht, von der Phasenlage des dritten Hochfrequenzimpulses ab.

Wenn dieser Hochfrequenzimpuls die gleiche zeitliche Phasenlage hat wie der erste Hochfrequenzimpuls HFa, wird die Kernmagnetisierung in den beiden äußeren Feldern der mittleren Zeile von Feldern in $-y'$-Richtung gekippt und in dem mittleren Feld in $-z'$-Richtung. Wenn der dritte Hochfrequenzimpuls HFc stattdessen jedoch um $180°$ in der Phase gedreht wird, weist die Kernmagnetisierung in den beiden äußeren Feldern in $+y'$-Richtung und im mittleren Feld in $+z'$-Richtung. Dies ist in Fig. c dadurch zum Ausdruck gebracht, daß in jedem Feld im oberen Teil die Richtung der Kernmagnetisierung für den ersten Fall und im unteren Teil des Feldes für den zweiten Fall angegeben ist. Entsprechendes kann durch eine $90°$-Phasenänderung von HFb erreicht werden.

Nach dem dritten Hochfrequenzimpuls HFc und vor dem nächsten Hochfrequenzimpuls wird ein magnetisches Gradientenfeld Gx3 ein- und ausgeschaltet, dessen Gradient in x-Richtung verläuft, jedoch auch in y- oder z-Richtung verlaufen kann. Dadurch wird die gesamte, durch die vorherigen Hochfrequenzimpulse erzeugte transversale Magnetisierung, d.h. die Magnetisierung, die nicht in $+z'$- oder $-z'$-Richtung zeigt, dephasiert insbesondere der durch HFc erzeugte FID. Infolgedessen können die vier mittleren Felder der oberen und unteren Reihe bzw. der linken und der rechten Spalte keinerlei Beitrag mehr leisten zu einem später erzeugten Kernresonanzsignal.

Im zeitlichen Abstand $t_2$ von dem dritten Hochfrequenzimpuls Hochfrequzenzimpuls HFc wird ein vierter Hochfrequenzimpuls HFd erzeugt. Der vierte Hochfrequenzimpuls HFd ist ein schichtselektiver $90°$-Impuls, der von einem magnetischen Gradientenfeld Gzd mit in z-Richtung verlaufendem Gradienten begleitet wird. Dadurch wird eine zur z-Achse senkrechte Schicht angeregt, die die Zeichenebene der Fig. 4 enthält. Nur in dieser Schicht wird die Kernmagnetisierung durch den $90°$-Hochfrequenzimpuls gekippt. Je nachdem, ob die Kernmagnetisierung in dem betreffenden Feld zuvor in $-z'$ oder in $+z'$ Richtung gerichtet war, klappt dieser Impuls die Kernmagnetisierung in Richtung $-y'$ bzw. $y'$. Dies ist wiederum in Fig. 4d eingetragen. Die so gekennzeichneten fünf Felder der Schicht liefern somit durch freien Induktionszerfall ein FID-Signal oder in Verbindung mit einem nachgeschalteten $180°$-Hochfrequenzimpuls ein Spin-Echo-Signal. Diese können zur Spektroskopie oder zur Bildgebung herangezogen werden.

Die aus Fig. 4d ersichtliche Tatsache, daß die Richtung der Kernmagnetisierung in dem zentralen Feld von der Phasenlage der drei ersten Hochfrequenzimpulse abhängig ist, während die Ausrichtung der Kernmagnetisierung in den vier Eckfeldern davon nicht berührt wird, ermöglicht die Durchführung eines Phasencyclings, bei dem der Einfluß der aus den Viereckfeldern herrührenden Komponenten des Kernresonanzsignals beseitigt wird. Dazu wird die in Fig. 3 dargestellte Sequenz ein weiteres Mal wiederholt, wobei lediglich die Phasenlage des dritten (oder des ersten) Hochfrequenzimpulses um 180° oder die des zweiten um 90° gedreht wird. Hat beispielsweise der dritte Hochfrequenzimpuls in der ersten Sequenz die gleiche Phasenlage wie der erste Hochfrequenzimpuls, dann hat in der zweiten Sequenz der dritte Hochfrequenzimpuls die entgegengesetzte Phasenlage wie der erste. Die von der Kernmagnetisierung in den vier Eckfeldern herrührenden Komponenten des Kernresonanzsignals haben dann die gleiche Phasenlage wie bei der ersten Sequenz, während die vom Zentralfeld herrührende Signalkomponente der entgegengesetzte Phasenlage hat. Durch Subtraktion der bei den beiden Sequenzen gewonnenen Kernresonanzsignale kann daher der Einfluß der von den Eckfeldern herrührenden Signalkomponenten beseitigt werden, so daß das resultierende Differenzsignal nur Signalkomponenten enthält, die von der Kernmagnetisierung im Zentralfeld, das dem Schnittbereich der durch die drei schichtselektiven Hochfrequenzimpulse HFa, HFc und HFd angeregten Schichten entspricht, bestimmt sind. Bei jeder Sequenz wird die volle Kernmagnetisierung ausgenutzt, woraus im Vergleich mit der STEVE-Methode ein besseren Signal-Rausch-Verhältnis resultiert.

Bei dem Ausführungsbeispiel nach Fig. 3 wird zur Zeit $t = t_3$ nach dem vierten Hochfrequenzimpuls ein fünfter Hochfrequenzimpuls HFe erzeugt, ein 180°-Impuls. Zur zweidimensionalen Abbildung der Kernmagnetisierungsverteilung in dem Zentralfeld (in x- und y-Richtung) wird zwischen dem vierten und dem fünften Hochfrequenzimpuls zu Zwecken der Phasencodierung ein magnetisches Gradientenfeld Gy1 wirksam gemacht, dessen zeitliches Integral nach jeweils zwei Sequenzen (bei denen die Phasenlage z.B. des dritten Hochfrequenzimpulses in bezug auf den ersten sich um 180° unterscheidet) stufenweise geändert wird. Es wird das Spin-Echo-Signal verarbeitet (indem der Taktimpulsgenerator 16 von der Steuereinrichtung 15 freigegeben wird -Fig. 2), das sein Maximum zur Zeit $t = t_3$ nach dem fünften Hochfrequenzimpuls hat. Beim Empfangen des Spin-Echo-Signals wird ein in x-Richtung verlaufendes magnetisches Gradientenfeld Gx5 eingeschaltet, das so gewählt ist, daß das zeitliche Integral über dieses Feld bis zum Maximum des Spin-Echo-Signals gerade so groß ist wie das zeitliche Integral über das magnetische Gradientenfeld Gx4.

Fig. 5 zeigt ein Ausführungsbeispiel für eine Sequenz, die es ermöglicht, direkt ein FID-Signal (oder ein Spin-Echo-Signal) aus dem Schnittbereich von drei durch Hochfrequenzimpulse angeregten Schichten zu erhalten. Diese Sequenz weist ebenso wie diejenige nach Fig. 3 vier Hochfrequenzimpulse auf, von denen der zweite (HFb) wiederum ein 180°-Hochfrequenzimpuls, während die drei anderen 90°-Impulse sein können. Der dritte und der vierte Hochfrequenzimpuls HFc bzw. HFd sind wiederum als schichtselektive Hochfrequenzimpulse ausgeführt, die von einem magnetischen Gradientenfeld Gyc bzw. Gzd begleitet werden. Im Gegensatz zu der Sequenz nach Fig. 3 ist der erste Hochfrequenzimpuls HFa jedoch nicht schichtselektiv, d.h. er wird nicht von einem magnetischen Gradientenfeld begleitet, während der 180°-Impuls HFb von einem magnetischen Gradientenfeld Gxb begleitet wird.

Die Wirkung dieser Sequenz auf die Kernmagnetisierung im Untersuchungsbereich wird anhand von Fig. 6 erläutert, die die Richtung der Kernmagnetisierung nach jedem der Hoch frequenzimpulse in neun Feldern innerhalb einer zur x-Achse senkrechten Schicht darstellt. Nach dem ersten Hochfrequenzimpuls HFa ist die Kernmagnetisierung im gesamten Untersuchungsbereich um 90° gekippt. Sie verläuft dann beispielsweise in Richtung $y'$. Die zeitlichen Integrale über die magnetischen Gradientenfelder Gx1 und Gx2, die vor und nach HFb wirksam sind, müssen gleich sein und der Gradient Gxb ist so gewählt, daß dessen Zeitintegrale vor und nach $t_1$ gleich sind. Dadurch wird erreicht, daß transversale Magnetisierung außerhalb der durch HFb und Gxb selektierten Schicht, die in der Zwischenebene von Fig. 6 liegt, dephasiert wird. Innerhalb dieser Schicht wird lediglich von HFb erzeugte transversale Magnetisierung dephasiert, wohingegen die restliche transversale Magnetisierung, deren Ausrichtung in der $x'$-$y'$ Ebene von den HF-Phasen von HFa und HFb abhängt, bei $t = 2\tau_1$ ein Spin-Echo bilden.

Der dritte Hochfrequenzimpuls beeinflußt die Kernmagnetisierung in einer zur Zeichenebene senkrechten Schicht, die die mittlere Spalte von Feldern enthält. Seine Phasenlage ist entweder die gleiche wie die des ersten Hochfrequenzimpulses oder sie ist gegenüber dieser um 180° versetzt. Dadurch wird in den drei Feldern der mittleren Spalte die Kernmagnetisierung je nach Phasenlage entweder in $-z'$-Richtung oder in $+z'$-Richtung gekippt, während sie in den beiden äußeren Spalten unverändert bleibt. Das zwischen dem dritten Hochfrequenzimpuls HFc und dem vierten Hochfrequenzimpuls HFd wirksame magnetische Gradientenfeld Gx2 dephasiert die transversale Kernmagnetisierung in den Bereichen beiderseits der durch den zweiten Hochfrequenzimpuls HFb angeregten Schicht (oberhalb und unterhalb der Zeichenebene) sowie in den sechs Feldern der beiden äußeren Felderspalten. Nur innerhalb der drei Felder der mittleren Spalte bleibt die in $+z$- oder $-z$-Richtung weisende Kernmagnetisierung bestehen.

Der vierte Hochfrequenzimpuls HFd wirkt auf eine zur z-Achse senkrechte Schicht ein, die horizontal und zur Zeichenebene senkrecht verläuft und die das mittlere der drei Felder der mittleren Spalte, das zentrale Feld einschließt. Nur in diesem zentralen Feld kann der vierte Hochfrequenzimpuls noch eine transversale Magnetisierung hervorrufen, da in den übrigen Bereichen der Schicht die Kernmagnetisierung durch den dritten Hochfrequenzimpuls HF₃ in z′-Richtung gedreht wurde. Infolgedessen steht nach dem vierten Hochfrequenzimpuls HFd ein Kernresonanzsignal zur Verfügung, das ausschließlich von der Kernmagnetisierung in dem Schnittbereich der drei durch die Hochfrequenzimpulse HFb bis HFd angeregten Schichten bestimmt ist. Danach kann wiederum mittels eines weiteren (nichtselektiven) 180°-Hochfrequenzimpulses ein Spin-Echo-Signal erzeugt werden, jedoch kann das FID-Signal, das vom vierten Hochfrequenzimpuls erzeugt wird, direkt ausgenutzt werden. Ebenso ist es möglich, das erhaltene Kernresonanzsignal sowohl zur Bildgebung als auch zur Spektroskopie heranzuziehen. In diesem Fall wird das Kernresonanzsignal, das nach dem Abschalten aller magnetischer Gradientenfelder auftritt, erfaßt und einer Fouriertransformation unterzogen - vorzugsweise nachdem die Sequenz genügend häufig wiederholt worden ist und die Kernresonanzsignale summiert worden sind.

Bei der Protonenspektroskopie ist es wesentlich, die Komponenten zu unterdrücken, die von an Wasser gebundenen Protonen herrühren. Dies kann durch Einfügen eines frequenzselektiven Hochfrequenzimpulses (binomialer Impuls, DANTE-Impuls) vor dem ersten und/oder dem vierten Hochfrequenzimpuls der Sequenz nach Fig. 3 bzw. 5 erfolgen, der nur diese Kernmagnetisierung anregt, die durch ein darauffolgendes magnetisches Gradientenfeld dephasiert wird, so daß sie zu dem nach dem vierten Hochfrequenzimpuls gewonnenen Kernresonanzsignl keinen Beitrag leistet. Ebenso können der HF-Puls HFb in Sequenz Fig. 3 bzw. HFa in Sequenz Fig. 5 frequenzselektiv gemacht werden, so daß er nur auf Protonen einer chemischen Verbindung (z.B. Fett) wirkt. Andere Komponenten werden dephasiert und tragen nicht mehr zum NMR-Signal bei.

Bei den Verfahren nach den Figuren 3 oder 5 ist der vierte Hochfrequenzimpuls HFd ein 90°-Impuls. Ersetzt man diesen vierten Hochfrequenzimpuls durch eine Folge von Kleinwinkelimpulsen mit nachfolgender Phasencodierung, so ist eine schnelle Abbildung des selektierten Volumenbereichs möglich. Unter Kleinwinkelimpulsen sind Hochfrequenzimpulse zu verstehen, die die Kernmagnetisierung um einen Winkel aus der z-Richtung kippen, der klein ist im Vergleich zu 90°, beispielsweise 10°.

Bei den zuvor beschriebenen Verfahren befindet sich der 180°-Hochfrequenzimpuls HFb genau in der Mitte zwischen dem ersten Hochfrequenzimpuls HFa und dem dritten Hochfrequenzimpuls HFC. Wenn HFb nicht genau in der Mitte liegt, funktionieren die Verfahren zwar immer noch, jedoch ergibt sich ein schlechteres Signal-Rausch-Verhältnis.

## Ansprüche

1. Verfahren zur Bestimmung der spektralen oder der räumlichen Verteilung der Kernmagnetisierung in einem Volumenbereich mit Hilfe einer Sequenz, die wenigstens drei schichtselektive Hochfrequenzimpulse umfaßt, wodurch drei zueinander senkrechte Schichten angeregt werden und das im Schnittbereich dieser Schichten erzeugte Kernresonanzsignal ausgenutzt wird,
dadurch gekennzeichnet, daß die Sequenz mindestens vier Hochfrequenzimpulse (HFa..HFd) umfaßt, von denen der erste (HFa), der dritte (HFc) und der vierte (HFd) schichtselektiv sind und je drei Schichten anregen, daß zwischen dem ersten und dem dritten Hochfrequenzimpuls -vorzugsweise in der Mitte - ein 180°-Hochfrequenzimpuls (HFb) vorgesehen ist, daß ein Phasencycling mit je zwei Sequenzen durchgeführt wird, und daß sich in diesen beiden Sequenzen die Phasenlage des ersten oder des dritten der vier Hochfrequenzimpulse um 180° oder die Phasenlage des zweiten um 90° unterscheidet

2. Verfahren zur Bestimmung der spektralen oder der räumlichen Verteilung in einem dreidimensionalen Volumenbereich mit Hilfe einer Sequenz, die wenigstens drei schichtselektive Hochfrequenzimpulse umfaßt, wodurch drei zueinander senkrechte Schichten angeregt werden und das in dem Schnittbereich der drei Schichten erzeugte Kernresonanzsignal ausgenutzt wird,
dadurch gekennzeichnet, daß die Sequenz wenigstens vier Hochfrequenzimpulse (HFa..HFb) umfaßt, von denen der zweite, der dritte und der vierte schichtselektiv sind und je drei Schichten anregen und daß der zweite zwischen dem ersten und dem dritten Hochfrequenzimpuls - vorzugsweise in der Mitte - liegende Hochfrequenzimpuls (HFb) ein 180°-Impuls ist.

3. Verfahren nach einem der vorhergehenden Ansprüche,
dadurch gekennzeichnet, daß zwischen dem dritten (HFc) und dem vierten Hochfrequenzimpuls (HFd) zur Dephasierung der nach dem dritten Hochfrequenzimpuls angeregten Kernmagnetisierung ein magnetisches Gradientenfeld (Gx3) wirksam gemacht wird.

4. Verfahren nach einem der vorhergehenden Ansprüche,
dadurch gekennzeichnet, daß dem vierten Hochfrequenzimpuls (HFd) ein fünfter Hochfrequenzimpuls (HFe) folgt, der als 180°-Impuls gestaltet ist und daß das von dem vierten und dem fünften Hochfrequenzimpuls erzeugte Spin-Echo-Signal ausgewertet wird.

5. Verfahren nach einem der vorhergehenden Ansprüche,
dadurch gekennzeichnet, daß der erste, (HFa) der dritte (HFc) und der vierte Hochfrequenzimpuls (HFd) 90°-Impulse sind.

6. Verfahren nach einem der Ansprüche 1 bis 3,
dadurch gekennzeichnet, daß der erste (HFa) und der dritte (HFc) Hochfrequenzimpuls 90°-Impulse sind und daß der vierte Hochfrequenzimpuls (HFd) als Kleinwinkelimpuls gestaltet ist, dem ein magnetisches Gradientenfeld folgt, und daß danach weitere gleichartige Kleinwinkelimpulse jeweils gefolgt von dem in der Amplitude und/oder der Dauer geänderten Gradientenfeld erzeugt werden.

7. Verfahren nach Anspruch 1 und 2,
dadurch gekennzeichnet, daß zwischen dem ersten (HFa) und dem zweiten (HFb) sowie zwischen dem zweiten und dem dritten (HFc) Hochfrequenzimpuls jeweils ein magnetisches Gradientenfeld (Gx1, Gx2) so wirksam gemacht wird, daß das zeitliche Integral über dieses Feld in beiden Fällen gleich ist.

8. Verfahren nach Anspruch 1 oder 2,
dadurch gekennzeichnet, daß die nicht schichtselektiven Hochfrequenzimpulse (HFa bzw. HFb) frequenzselektiv sind.

9. Anordnung zur Durchführung des Verfahrens nach einem der vorhergehenden Ansprüche,
gekennzeichnet durch einen Magneten (1) zur Erzeugung eines homogenen stationären Magnetfeldes, eine Hochfrequenzspule (11) zur Erzeugung eines zur Richtung des stationären Magnetfeldes senkrechten hochfrequenten Magnetfeldes, einem Hochfrequenzgenerator (4) zur Speisung der Hochfrequenzspule mit Signalen, deren Frequenz steuerbar ist, mehreren Gradientenspulen (3,5,7) zur Erzeugung von Magnetfeldern, die in der gleichen Richtung verlaufen wie das stationäre Magnetfeld und deren Gradienten unterschiedlichen Richtungen verlaufen, Generatoren (23,25,27), die den Gradientenspulen je einen Strom mit vorgebbarer Amplitude zuführen und eine Steuereinheit (15), die den Hochfrequenzgenerator und die Generatoren für die Gradientenspulen so steuert, daß vier Hochfrequenzimpulse erzeugt werden, von denen die beiden letzten sowie einer der beiden ersten schichtselektiv sind, wobei der zweite Hochfrequenzimpuls ein 180°-Impuls ist.

Fig. 1

Fig. 2

Fig. 3

a)    b)    c)    d)

Fig. 4

3-Ⅳ-PHD 89-031

Fig. 5

Fig. 6